## Europäisches Patentamt
## European Patent Office
## Office européen des brevets

(11) Numéro de publication: **0 254 601**
**A1**

# (12) DEMANDE DE BREVET EUROPEEN

(21) Numéro de dépôt: **87401160.4**

(22) Date de dépôt: **22.05.87**

(51) Int. Cl.⁴: **G 01 R 29/12**
G 01 R 15/07, G 01 D 5/26

(30) Priorité: **27.05.86 FR 8607567**

(43) Date de publication de la demande:
**27.01.88 Bulletin 88/04**

(84) Etats contractants désignés: **DE FR GB IT NL**

(71) Demandeur: **COMMISSARIAT A L'ENERGIE ATOMIQUE**
**29-31, rue de la Fédération**
**F-75015 Paris (FR)**

(72) Inventeur: **Chollet, Pierre-Alain**
**13, rue des Leux**
**F-92140 Clamart (FR)**

**Kajzar, François**
**28, rue Maurice Nogues**
**F-78960 Voisins Le Bretonneux (FR)**

**Messier, Jean**
**27, avenue des Roches**
**F-91190 Gif Sur Yvette (FR)**

(74) Mandataire: **Mongrédien, André et al**
**c/o BREVATOME 25, rue de Ponthieu**
**F-75008 Paris (FR)**

(54) **Dispositif de mesure de champ électrostatique par une méthode optique.**

(57) Dispositif de mesure de champs électrostatiques comprenant principalement un laser (1) et une sonde (3) pourvue d'un feuil de polymère (4) centrosymétrique permettant la génération, sous l'action du champ, de l'harmonique deux de l'onde lumineuse émise. Des fibres optiques (20, 23) transportent les ondes incidente et réfléchie du laser (1) à la sonde (3), puis à une chaîne de mesure optique (7, 8, 9, 10).

Ce dispositif intéresse en particulier la mesure de champs électriques entre câbles coaxiaux à haute tension.

FIG. 2

EP 0 254 601 A1

## Description

### DISPOSITIF DE MESURE DE CHAMP ELECTROSTATIQUE PAR UNE METHODE OPTIQUE

L'objet de la présente invention est un dispositif de mesure de champ électrostatique par une méthode entièrement optique.

Les procédés actuellement connus consistent en effet à déterminer le seuil d'apparition de décharges électriques entre un couple d'électrodes plongées dans une atmosphère neutre telle qu'un gaz rare. Ils ne sont pas satisfaisants car ils impliquent une mise en oeuvre compliquée (création d'une enceinte de confinement du gaz) et obligent à introduire une charge résistive supplémentaire qui perturbe les lignes de champ caractéristiques du phénomène à étudier.

L'invention se propose donc d'établir la cartographie de champs électrostatiques au moyen d'un dispositif qui n'inclut aucun corps conducteur à proximité des points de mesure.

A cet effet, elle comprend une sonde disposée à l'endroit où on veut mesurer le champ électrostatique, comportant un feuil de polymère centrosymétrique, un laser d'excitation de grande puissance émettant une lumière monochromatique de pulsation ω, et un système de fibres optiques conduisant la lumière entre le laser et la sonde d'une part, de la sonde à une chaîne d'observation de la lumière de pulsation 2 ω dont l'existence signifie la présence d'un champ électrostatique au voisinage de la sonde et dont l'intensité est caractéristique de l'amplitude de ce champ, d'autre part.

Dans un mode de réalisation préféré, le polymère centrosymétrique est un polydiacétylène, dont l'épaisseur est égale à la longueur de cohérence, définie plus loin et qui est fonction du polymère et de la longueur d'onde de la lumière émise par le laser.

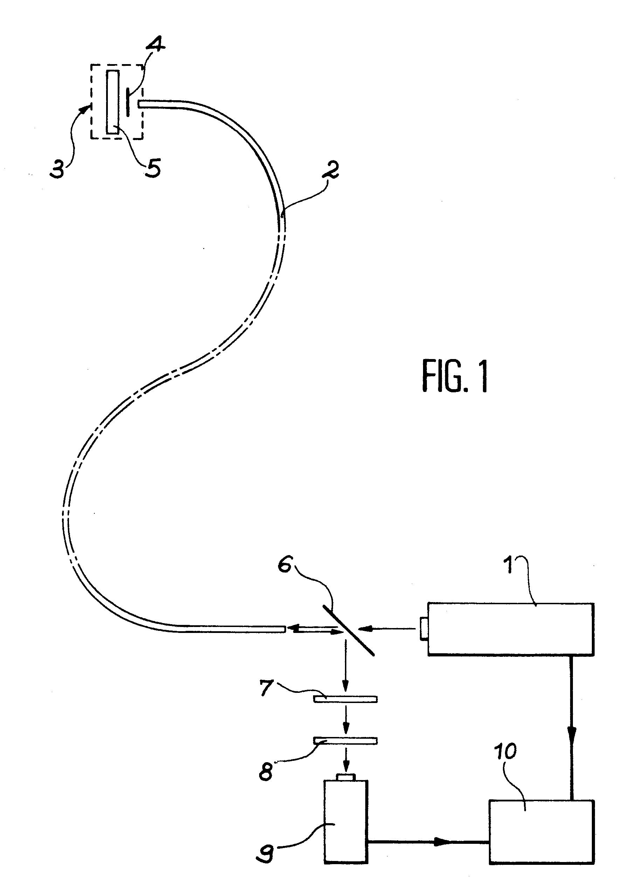

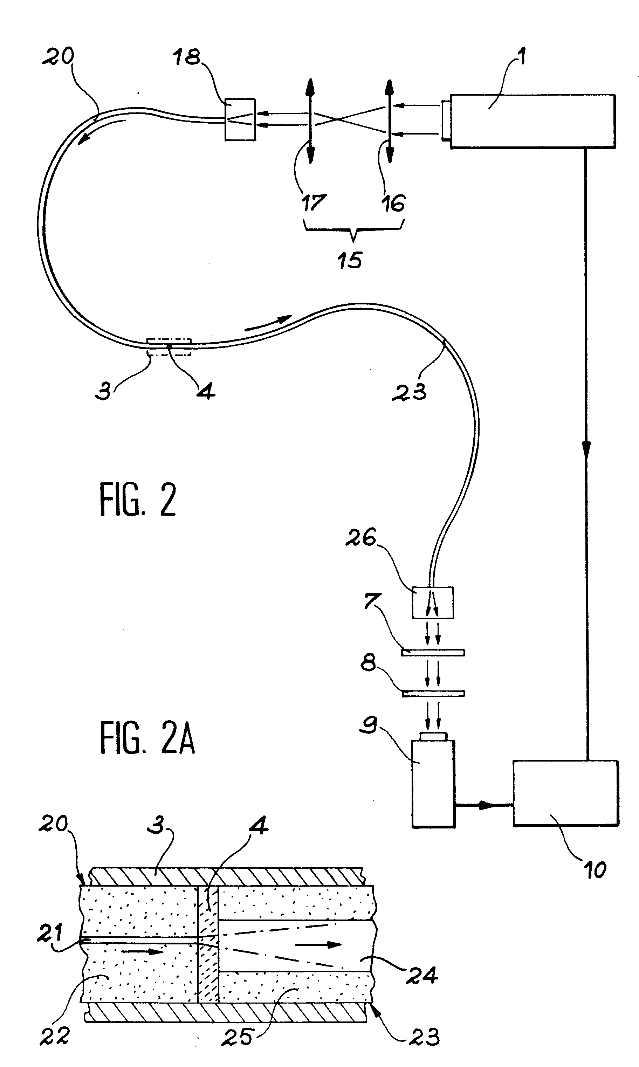

Cette invention sera mieux comprise d'après la description qui va suivre, donnée à titre illustratif et nullement limitatif, et qui se rapporte aux figures 1, 2 et 2A qui représentent deux réalisations possibles de l'invention, la figure 2A étant un agrandissement de la figure 2.

D'après la figure 1, on représente un laser 1 de type YAG qui émet un faisceau monochromatiqué de pulsation ω et de longueur d'onde $\lambda_\omega$ par impulsions d'une fréquence de l'ordre du kilohertz. La puissance surfacique émise est avantageusement d'environ un mégawatt par centimètre carré. L'onde est transmise par une fibre optique 2 de quartz vers une sonde de champ électrostatique 3. La longueur de cette fibre optique 2 est conditionnée par la nécessité de ne pas perturber le champ par les corps conducteurs de l'appareil. L'atténuation des fibres optiques, inférieure un dixième de décibel pour une longueur de dix mètres, ne pose en principe pas de contrainte. La sonde 3 est munie d'un feuil de polymère centrosymétrique 4 tel qu'un polydiacétylène de forme bleue de chaîne caractéristique R-$\overset{\text{ii}}{\text{c}}$-C≡C-$\overset{\text{i}}{\text{c}}$-R où R est un groupement moléculaire qui dépend du polydiacétylène.

En raison de leur nature centrosymétrique, ces corps soumis à une onde lumineuse ne peuvent généralement pas émettre d'harmoniques deux de cette onde, mais uniquement des rayonnements d'harmoniques impairs de pulsation ω , 3ω ,... Les conditions sont différentes quand le polymère est plongé dans un champ électrique : des travaux préliminaires des auteurs de l'invention, résumés dans "Electric field induced optical second harmonic generation and polarization effects in polydiacetylene films" (Polydiacetylenes, édité par D. Bloor et R.R. Chance, NATO ASI Series, Series E : applied sciences n°102), montrent qu'une émission d'onde d'harmonique deux est alors possible.

Il est possible de démontrer que son intensité $I_2$ est proportionnelle à $I\omega^2 E^2/S$, où $I\omega$ désigne l'intensité de la lumière émise par le laser 1 arrivant sur le polymère, E le champ électrique à mesurer, S la surface du polymère exposée la lumière de longueur d'onde émise par le laser 1. Les inventeurs ont constaté que l'intensité lumineuse d'harmonique deux varie en fonction de l'épaisseur du feuil de polymère 4 d'après une fonction sinusoïdale due au déphasage entre une onde due à la polarisation du polymère et de longueur d'onde$\lambda_\omega/2n$ ω, et une onde émise par les dipôles du polymère vibrant à la pulsation 2ω, et de longueur d'onde$\lambda_\omega/2n_{2\omega}$ où $n_{2\omega}$ et $n\omega$ sont les indices du polymère aux ondes de pulsation 2ω et ω. Cette intensité atteint son maximum quand l'épaisseur du feuil est égale à un multiple impair de la longueur de cohérence $I_c = \lambda_\omega/4(n_{2\omega}-n\omega)$ et de préférence égale cette longueur de cohérence où l'absorption est la plus faible ; dans le cas du polydiacétylène de forme bleue, ils ont montré l'intérêt de la longueur d'onde $\lambda_\omega \geqq 1,1\mu m$ où il n'apparaît aucune polarisation en champ continu, et plus précisément de la longueur 1,3μm environ où le signal utile est maximal et où l'absorption par le feuil lui-même ou par le matériau des fibres optiques est faible.

Ces polymères centrosymétriques sont avantageusement obtenus par évaporation de solvant.

Une onde produite par le passage de la lumière dans le polymère et comprenant une composante de pulsation 2 de grande intensité est alors, selon ce mode particulier de réalisation de l'invention, réfléchie par un miroir 5 disposé dans la sonde 3 dans la même fibre optique 2 qui assure la circulation de l'onde incidente. Elle est transmise au moyen d'une lame séparatrice 6 à une chaîne de mesure constituée typiquement d'un filtre 7 Schott K63 qui élimine la composante parasite de pulsation ω , d'un monochromateur 8 MTO DA 621C qui isole la composante utile de pulsation 2 ω, d'un photomultiplicateur 9 et d'un détecteur photosensible 10 synchronisé avec le laser 1 et qui assure l'intégration temporelle et la mesure des signaux recueillis.

Ce dispositif permet donc, après sélection et étalonnage du feuil de polydiacétylène sélectionné, apte à fournir un harmonique deux suivant un phénomène de résonance optique, une mesure précise et fiable des champs électriques. Le capteur peut être de très petites dimensions, l'épaisseur du feuil de polymère étant de l'ordre de quelques microns ; des mesures fines sont donc possibles.

Le mode de réalisation décrit jusqu'ici n'est toutefois pas le seul envisageable, comme on le voit sur les figures 2 et 2A. Les éléments communs aux deux réalisations portent les mêmes références.

La lumière excitatrice, de longueur d'onde $\lambda\omega =$ 1,32 µm, est émise par le laser YAG 1 sous forme d'un faisceau de 2 mm de diamètre suivant des pulsations de fréquence 1 kHz durant 1 µs et de puissance 100W. Ce diamètre est tout d''abord réduit par un télescope 15 formé de deux lentilles convergentes 16 et 17 dont la distance est égale à la somme de leurs distances focales ; le faisceau arrive ensuite à une lentille 18 dite "SELFOC" qui l'introduit dans le coeur 21 d'une fibre optique monomode 20 en silice.

Le coeur 21 a un diamètre de 7 µm, et la gaine 22 de la fibre optique monomode 20 un diamètre extérieur de 125 µm. La lumière excitatrice est alors acheminée au feuil de polymère 4 dont l'épaisseur, égale à la longueur de cohérence, est ici d'environ 5 µm pour un polydiacétylène de forme bleue. Elle passe ensuite dans le coeur 24 d'une fibre optique multimode 23 de retour en silice en même temps que la lumière d'harmonique deux engendrée par l'excitation du feuil de polymère 4. Le diamètre du coeur 24 est 50 µm, le diamètre extérieur de la gaine 25 de la fibre optique multimode 23 est 125 µm.

La lumière sort de la fibre optique multimode de retour 23 par une seconde lentille "SELFOC" 26. L'analyse peut ensuite s'effectuer au moyen des mêmes appareils que dans la réalisation précédente : filtre 7, monochromateur 8, photomultiplicateur 9 et détecteur photosensible 10.

Comme les fibres optiques 20 et 23 pour l'arrivée et le retour de la lumière par rapport au feuil de polymère 4 sont différentes, il n'est évidement plus question d'un miroir 5 dans la sonde 3 et d'une lame séparatrice 6. Le motif de cette construction différente est expliqué ci-dessous.

Il est en effet nécessaire d'obtenir une intensité lumineuse d'ordre deux qui soit mesurable. La formule de $I_{2\omega}$ exposée plus haut montre que cette intensité peut être facilement augmentée en diminuant la surface de polymère exposée à la lumière incidente, ce qui justifie l'utilisation de la fibre monomode 20 dont le coeur 21 a un fin diamètre. Par contre, un diamètre plus important est préférable pour le coeur 24 de la fibre optique de retour 23, afin de recueillir la totalité de la lumière ayant passé dans le polymère.

On peut encore redouter que les fibres optiques, dont une partie est d'ailleurs plongée dans le champ électrique à mesurer, n'engendrent également une composante lumineuse d'ordre deux, d'autant plus que l'épaisseur du polymère est très faible (quelques microns) par rapport à la longueur totale des fibres optiques (plusieurs mètres).

Mais, comme on l'a vu, l'émission d'harmonique deux est un phénomène qui n'est pas proportionnel à la longueur traversée ; et de plus, comme l'intensité de lumière d'ordre deux $I_{2\omega}$ est également proportionnelle à $[\tau \, lc \, (\sin\pi d/2lc)]^2$, où d est la longueur du trajet parcouru par la lumière dans le matériau et $\tau$ un coefficient de susceptibilité de ce matériau, on peut démontrer que, même dans le cas où la longueur des fibres optiques permettrait une émission maximale, cette émission serait négligeable par rapport à celle du polymère.

Pour une longueur d'onde excitatrice proche de 1,3 µm, les susceptibilités du polydiacétylène et de la silice sont respectivement $10^{-18}$ et $4.10^{-22}$ $m^2/V^2$, et leurs longueurs de cohérence 5 et 34 µm. Le rapport des intensités lumineuses d'ordre deux est donc supérieur à $1,3.10^5$, ce qui signifie que la contribution des fibres optiques est absolument négligeable.

Evidemment, les valeurs numériques fournies ici ne sont données qu'à titre illustratif ; elles ne sont pas indispensables à une réalisation correcte de l'invention et ne doivent donc pas être interprétées dans un sens restrictif.

Dans tous les cas, on obtient un capteur sans partie conductrice, qui ne perturbe donc pas le phénomène à mesurer, de très petite taille et dont la réponse est très rapide (de l'ordre de la picoseconde) et limitée en fait par l'électronique de la chaîne d'observation.

Une utilisation importante de l'invention pourra être la mesure de champs électrostatiques au voisinage de câbles coaxiaux de haute tension.

**Revendications**

1. Dispositif de mesure d'un champ électrostatique par voie optique, caractérisé en ce qu'il comprend :
- une sonde (3) disposé à l'endroit où l'on veut mesurer le champ électrostatique, comportant un feuil de polymère (4) centrosymétrique émettant une lumière d'ordre deux quand il est plongé dans un champ électrique,
- un laser (1) d'excitation de grande puissance émettant une lumière monochromatique de pulsation ω,
- un système de fibres optiques (2, 20, 23) conduisant la lumière entre le laser (1) et la sonde (3) d'une part, de la sonde (3) à une chaîne d'observation (7, 8, 9, 10) de la lumière de pulsation 2 ω dont l'existence signifie la présence d'un champ électrostatique au voisinage de la sonde (3) et dont l'intensité est caractéristique de l'amplitude de ce champ, d'autre part.

2. Dispositif de mesure selon la revendication 1, caractérisé en ce que le feuil de polymère centrosymétrique (4) est obtenu par évaporation de solvant.

3. Dispositif de mesure selon la revendication 1, caractérisé en ce que le feuil de polymère centrosymétrique (4) a une épaisseur égale à un multiple impair de la longueur de cohérence (lc) du dispositif.

4. Dispositif de mesure selon la revendication 1, caractérisé en ce que le polymère centrosymétrique est un polydiacétylène.

5. Dispositif de mesure selon la revendication 4, caractérisé en ce que le polydiacétylène est de forme bleue.

6. Dispositif de mesure selon la revendication 5, caractérisé en ce que la longueur d'onde du laser (1) est supérieure à 1,1 μm pour éviter une polarisation du polymère.

7. Dispositif de mesure selon la revendication 5, caractérisé en ce que la longueur d'onde du laser (1) est de l'ordre de 1,3 μm pour obtenir le signal à la pulsation 2ω tout en évitant une absorption trop importante par le feuil (4) ou par les fibres optiques (2, 20, 23).

8. Dispositif de mesure selon l'une quelconque des revendications précédentes, caractérisé en ce que les fibres optiques sont en silice.

9. Dispositif de mesure selon l'une quelconque des revendications précédentes, caractérisé en ce que le système de fibres optiques comprend une fibre optique (2) unique véhiculant la lumière dans les deux sens, et en ce que la sonde (3) comprend un miroir (5) qui réfléchit la lumière ayant traversé le feuil de polymère (4) vers ladite fibre optique.

10. Dispositif de mesure selon l'une quelconque des revendications précédentes, caractérisé en ce que le système de fibres optiques comprend une fibre monomode (20) conduisant la lumière entre le laser (1) et la sonde (3) et une fibre multimode (23) conduisant la lumière de la sonde (3) à la chaîne d'observation (7, 8, 9, 10).

0254601

FIG. 1

0254601

FIG. 2

FIG. 2A

Office européen des brevets

# RAPPORT DE RECHERCHE EUROPEENNE

Numero de la demande

EP 87 40 1160

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl 4) |
|---|---|---|---|
| A | EP-A-0 146 522 (MONSANTO)<br>* Abrégé; page 3, ligne 7 - page 4, ligne 24; page 5, ligne 22 - page 6, ligne 34; revendication 1; figure 2 * | 1,9 | G 01 R 29/12<br>G 01 R 15/07<br>G 01 D 5/26 |
| A | EP-A-0 095 998 (ASEA AB)<br>* Page 3, ligne 31 - page 6, ligne 5; figures 1-2,4 * | 1 | |
| A | TECHNISCHES MESSEN, vol. 51, no. 6, juin 1984, pages 205-212, Münich, DE; R. KIST: "Messwerterfassung mit faseroptischen Sensoren"<br>* Page 205, colonne 2, ligne 1 - page 206, colonne 1, ligne 19; page 207, colonne 2, ligne 5 - page 208, colonne 1, ligne 28; page 209, colonne 1, lignes 7-39; figures 1,8-9 * | 1,10 | |
| A | WO-A-8 404 439 (CENTRAL ELECTRICITY GENERATING BOARD)<br>* Abrégé; page 23, ligne 4 - page 24, ligne 16; figures 1,7-8,12 * | 1,9-10 | |

--- -/-

DOMAINES TECHNIQUES RECHERCHES (Int. Cl.4)

G 01 R 29/00
G 01 R 15/00
G 01 D 5/00

Le présent rapport de recherche a été établi pour toutes les revendications

| Lieu de la recherche | Date d'achèvement de la recherche | Examinateur |
|---|---|---|
| LA HAYE | 01-10-1987 | TRELEVEN C. |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl 4) |
|---|---|---|---|
| A | LASER FOCUS, vol. 22, no. 3, mars 1986, pages 56,58,60,62,66,68, Littleton, Massachusetts, US; B. DANCE: "Advances in fiberoptic developments in the U.K." * Page 58, colonne 3, ligne 9 - page 60, colonne 2, ligne 1 * | 7 | |
| A | WIRE INDUSTRY, vol. 52, no. 10, octobre 1985, pages 649-652, Oxted, Surrey, GB; C. OVREN et al.: "New opportunities with fibre optic measurement" * Page 651, colonne 1, lignes 8-12 * | 8 | |
| A | EP-A-0 130 337 (IBM) * Page 12, lignes 16-25; figures 3,8 * | 9,10 | DOMAINES TECHNIQUES RECHERCHES (Int. Cl.4) |
| A | JOURNAL OF OPTICAL COMMUNICATIONS, vol. 2, no. 1, mars 1981, pages 7-10, Fachverlag Schiele & Schon, Berlin, DE; Y. HAMASAKI et al.: "Optical fiber sensor for the measurement of electric field intensity and voltage (OPSEF)" * Page 7, colonne 1, ligne 1 - page 8, colonne 2, ligne 26; figures 1-2 * | 1,10 | |

Le présent rapport de recherche a été établi pour toutes les revendications

| Lieu de la recherche | Date d'achèvement de la recherche | Examinateur |
|---|---|---|
| LA HAYE | 01-10-1987 | TRELEVEN C. |